# EUROPEAN PATENT SPECIFICATION

(11) **EP 1 256 986 B1**
(45) Date of publication and mention of the grant of the patent: **01.12.2010**
(21) Application number: 02250034.2
(22) Date of filing: 04.01.2002
(51) Int. Cl.: H01L 29/788

(54) **Single electron memory device and method for manufacturing the same**
Einzelelektron-Speicheranordnung und Verfahren zur Herstellung
Dispositif de mémoire à électron unique et procédé pour sa fabrication

(30) Priority: 10.05.2001 KR 2001025569
(43) Date of publication of application: 13.11.2002
(73) Proprietor: SAMSUNG ELECTRONICS CO., LTD., Suwon-City, Kyungki-do (KR)
(72) Inventor: Chae, Soo-doo, Gangseo-gu, Seoul (KR); Kim, Byong-man, c/o Samsung Adv. Inst. of Techn., Yongin-city, kyungki-do 449-712 (KR); Kim, Moon-kyung, c/o Samsung Advanced Institute, Yongin-city, Kyungki-do (KR); Chae, Hee-soon, c/o Samsung Advanced Institute, Yongin-city, Kyungki-do (KR); Ryu, Won-il, Gangnam-gu, Seoul (KR)
(74) Representative: Greene, Simon Kenneth

(56) References cited:
- EP-A- 0 843 360
- US-A- 5 937 295
- US-A- 6 060 743
- US-B1- 6 208 000
- PATENT ABSTRACTS OF JAPAN vol. 1997, no. 06, 30 June 1997 (1997-06-30) -& JP 09 036317 A (MATSUSHITA ELECTRIC IND CO LTD), 7 February 1997 (1997-02-07)
- OHBA R ET AL: "Non-volatile Si quantum memory with self-aligned doubly-stacked dots" INTERNATIONAL ELECTRON DEVICES MEETING 2000. TECHNICAL DIGEST. IEDM (CAT. NO.00CH37138), INTERNATIONAL ELECTRON DEVICES MEETING. TECHNICAL DIGEST. IEDM, SAN FRANCISCO, CA, USA, 10-13 DEC. 2000, pages 313-316, XP010531770 2000, Piscataway, NJ, USA, IEEE, USA ISBN: 0-7803-6438-4
- PATENT ABSTRACTS OF JAPAN vol. 2000, no. 08, 6 October 2000 (2000-10-06) -& JP 2000 150862 A (TOSHIBA CORP), 30 May 2000 (2000-05-30)

## Description

The present invention relates to a memory device and method for manufacturing the same, and more particularly, to a single electron memory device comprising quantum dots between a gate electrode and a single electron storage element and method for manufacturing the same.

As the size of a metal-oxide semiconductor field effect transistor (MOSFET) becomes smaller, problems that do not occur before occur in the MOSFET. Thus, it becomes difficult to further reduce the size of the MOSFET. For example, as the size of the device becomes smaller, problems such as lowering of threshold voltage caused by decrease in effective channel length, drain induced barrier lowering (DIBL), punchthrough, deterioration of an oxide layer and increase in leakage current, which are caused by hot carriers generated by an increase in an electrical field in the devices, occur in the MOSFET. These problems are main factors that make reduction of the size of a MOSFET difficult.

However, the most important problem to be solved is a physical limit which faces in a case where the size of the MOSFET is in the range of nanometers (nm) by continuously scaling the MOSFET. That is, the number of electrons participating in an operation of a device becomes similar to the number of thermally fluctuating electrons in a miniaturized MOSFET, and thus a proper operation at room temperature can not be expected.

To overcome this problem, the development of a new device technique which is capable of replacing a complementary MOSFET (CMOSFET), which represents integrated circuit techniques, is required. A single electron transistor (SET) is a device which has been recently studied as an alternative to a new device.

Coulomb blockade becomes a physical principle for the single electron device and means that tunneling is blocked on specific conditions in which free energy of a total system consisting of charging energy and electrostatic energy for a junction capacitance increases or decreases when electrons tunnel through a tunnel junction having a minute size.

The SET is a switching device which controls current flowing through two tunnel junctions between quantum dots by controlling Coulomb blockade conditions through a gate potential which is capacitively coupled to the quantum dots.

Meanwhile, quantum dots coupled to a channel through a tunnel junction are used as a storage electrode in a single electron memory device, and the single electron memory device is a memory device for recognizing variation in channel current due to charges stored in the quantum dots as information "0" or "1".

Unlike the MOSFET, in the single electron device, the smaller the device is the less are effects caused by thermal fluctuation. The property of the device is determined by the capacitance between elements constituting the device the device than the structure of the device, and thus, the single electron device is advantageous for device scaling.

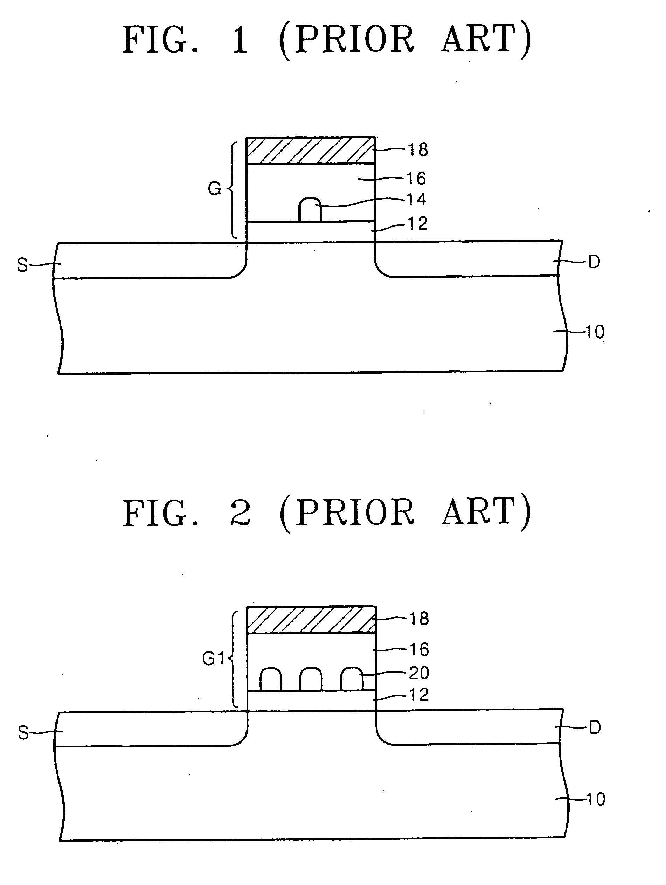

Conventional single electron memory devices include a device for storing electrons in a single quantum dot 14, as shown in FIG. 1, and a device having a hybrid structure in which a nano-crystal array 20 having high distribution density is used as a storage electrode and a MOSFET is used as a sense device, as shown in FIG. 2. Reference numeral 10 in FIGS. 1 and 2 denotes a substrate, and reference characters S and D denote a source and a drain, and reference characters G and G1 denote a gate lamination. In FIG. 1, the gate lamination G consists of a tunneling oxide layer 12 formed on the substrate 10 between a source S and a drain D, a single quantum dot 14, and a control oxide layer 16 and a gate electrode 18 which cover the single quantum dot 14. In FIG. 2, the gate lamination G1 is the same as those of FIG. 1 but include a nano-crystal array 20, instead of the single quantum dot 14.

The quantum dot 14 of the single electron memory device shown in FIG. 1 is formed using a nano-lithography technique, and the nano-crystal array of the single electron memory device shown in FIG. 2 is formed utilizing a self-assembled growth method.

In the single electron memory devices, the thickness of the tunneling oxide layer 12 is the main factor determining the reliability of the device such as retention time of information, together with speed of write/erase, and the thickness of the control oxide layer 16 and the distribution density of the quantum dot is the main factor determining the size of variation in threshold voltage.

However, in the conventional single electron memory devices, the quantum dot or the nano-crystal array is formed on the tunneling oxide layer 12, and thus, defects can occur in the tunneling oxide layer 12 while forming the quantum dot or the nano-crystal array, resulting in changing the properties of the devices and causing many limitations in formation of the quantum dot on the tunneling oxide layer 12.

For example, in order to implement single electron tunneling at room temperature, preferably, the size of the quantum dot is less than 10 nm in a case where the quantum dot is formed of silicon. It is difficult to form the quantum dot having a predetermined size due to the possibility of causing defects in the tunneling oxide layer, and it becomes difficult to manufacture a single electron memory device which operate at room temperature. Further, retention time of information does not reach a practical standard.

EP 0843360 describes a memory device using nanoscale conductive islands, for example of silicon, to store charge in a barrier gate structure.

Accordingly, to achieve the first object, according to one aspect of the present invention, there is provided a single electron memory device according to claim 1.

The present invention may accordingly provide, a single electron memory device which is capable of retaining information long enough to be practical and preventing variation in the properties of a device when forming quantum dots or an element having the same effects.

The quantum dots are included on the upper layer and are not in contact with the single electron storage medium or in a state where is in contact with the single electron storage medium.

The upper layer may be formed of first and second upper layers and the quantum dots are included in the second upper layer.

The single electron storage medium is formed of a material selected from the group consisting of nano scale silicon nitride (Si₃N₄) having a quantized trap site at an interface with the lower layer or in a bulk, silicon (Si), silicon germanium (SiGe), and gallium arsenide (GaAs).

According to one aspect of the present invention, there may be provided a method for manufacturing a single electron memory device according to claim 7.

The step (b) may include the steps of forming a first upper layer on the single electron storage medium, forming the quantum dots on the first upper layer, and forming a second upper layer to cover the quantum dots on the first upper layer.

The single electron storage means is quantum dots or the single electron storage medium.

The single electron memory device according to the present invention includes a silicon nitride layer as a nano scale storage medium between quantum dots which are included on the bottom surface of a gate electrode, and a tunneling layer formed on a nano scale channel region. As a result, the silicon nitride layer can be locally charged even in a nano scale, and can retain information longer than a conventional single electron memory device using quantum dots as a data storage electrode. Further, the quantum dots are not included in a lower layer as a tunneling layer, but in an upper layer, thereby maintaining the properties of a device and allowing the quantum dots to be formed by various methods.

The above objects and advantages of the present invention will become more apparent by describing in detail preferred embodiments thereof with reference to the attached drawings in which:
FIGS. 1 and 2 are sectional views of conventional single electron memory devices;
FIGS. 3 through 6 are sectional views of a single electron memory device comprising quantum dots between a gate electrode and a single electron storage element according to first through fourth embodiments of the present invention, respectively;
FIGS. 7 through 10 are sectional views illustrating step by step a method for manufacturing the single electron memory device of FIG. 3;
FIGS. 11 and 12 are sectional views illustrating step by step a method for manufacturing the single electron memory device of FIG. 4;
FIGS. 13 and 14 are sectional views illustrating step by step a method for manufacturing the single electron memory device of FIG. 5; and
FIGS. 15 and 16 are sectional views illustrating step by step a method for manufacturing the single electron memory device of FIG. 6.

Hereinafter, preferred embodiments of the present invention will be described in detail with reference to the accompanying drawings. The thickness of layers or regions shown in the drawings may be exaggerated for clarity. Like reference numerals denote like materials throughout the drawings. Also, detailed descriptions of structures and procedures are provided only in the description of the embodiment of the present invention in which those structures and procedures are first introduced.

First, embodiments of a single electron memory device according to the present invention will be described.

### <Embodiment 1>

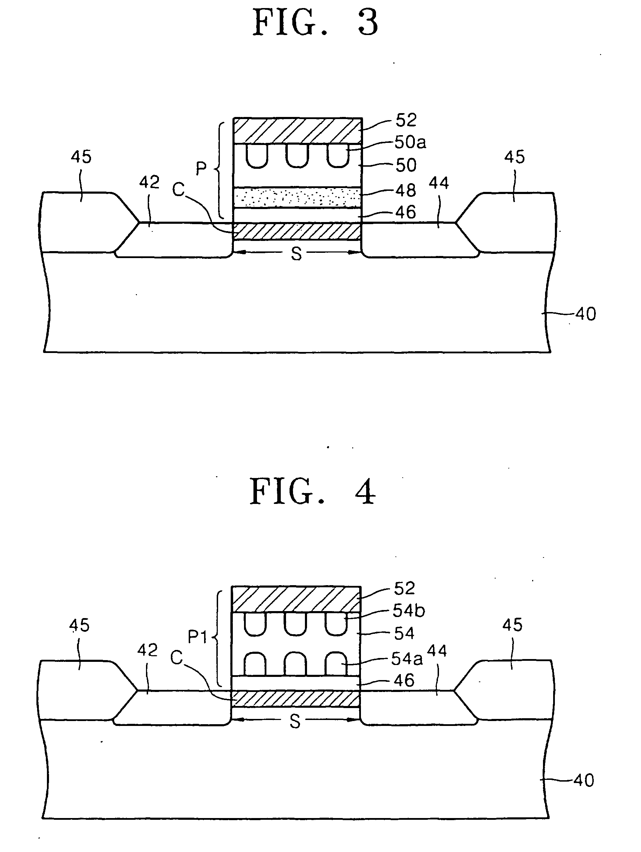

Referring to FIG. 3, reference numeral 40 denotes a substrate on which a MOSFET is formed and may be a P-type or N-type semiconductor substrate, for example, a silicon substrate, according to the type of the MOSFET. Reference numerals 42 and 44 denote first and second conductive impurity regions which are formed on the substrate 40, that is, a source region and a drain region. Reference numeral 45 denotes a field oxide layer, that is, LOCOS-type oxide layer. The first and second conductive impurity regions 42 and 44 are spaced apart from each other by a distance S of several tens of nanometers (nm). As a result, the scale of a channel region C formed on the upper portion of the substrate 40 between the first and second conductive impurity regions 42 and 44 is nano scale. A gate lamination pattern P is formed on the channel region C. The gate lamination pattern P consists of a lower layer 46, a single electron storage medium 48, an upper layer 50, and a gate electrode 52, which are sequentially formed. The lower layer 46 is a tunneling layer for tunneling a single electron. Preferably, the lower layer 46 is formed of a material selected from the group consisting of silicon oxide (SiO₂), alumina (Al₂O₃), tantalum oxide (TaO₂), and titanium oxide (TiO₂), and most preferably silicon oxide (SiO₂) to a thickness of several nanometers (for example, less than 5 nm). Preferably, the single electron storage medium 48 is formed of silicon nitride (Si₃N₄) of nano scale having a quantized trap site at an interface with the lower layer 46 or in a bulk. However, the single electron storage medium 48 may be formed of silicon (Si) or other semiconductor and metal materials. Preferably, the upper layer 50 is formed of the same material as the lower layer 46, for example, silicon oxide (SiO₂), but may be formed of a material different from the lower layer 46.

Quantum dots 50a are included in the upper layer 50. Specifically, the quantum dots 50a are not in contact with the single electron storage medium 48 but are in contact with the bottom surface of the gate electrode 52. That is, the gate electrode 52 is formed on a surface consisting of an upper surface of the quantum dots 50a and the upper layer 50. The quantum dots 50a in the upper layer 50 charge a region corresponding to the single electron storage medium 48, that is, locally charge the single electron storage medium 48. Thus, the size of the quantum dots 50a is preferably small enough to implement single electron tunneling at room temperature. For example, in a case where the quantum dots 50a are formed of silicon (Si), the size of the quantum dots 50a is preferably less than 10 nm. The gate electrode 52 is formed of a semiconductor such as silicon (Si) or a metal.

Meanwhile, although not shown, a gate spacer may be further formed at the side of the gate lamination pattern P, and in this case, the first and second conductive impurity regions 42 and 44 are LDD-types including impurity regions into which impurities are deeply injected by using the gate spacer as a mask.

The operation of the single electron memory device will now be described. When voltage is applied to the gate electrode 52, the single electron storage medium 48 is charged with a single electron tunneling through the lower layer 46 by coupling the nano scale channel region C to the quantum dots 50a contacting the bottom surface of the gate electrode 52, resulting in a new Coulomb blockade. That is, even if the voltage applied to the gate electrode 52 after the single electron storage medium 48 is charged with the single electron increases by a predetermined value, further electron tunneling does not occur. That is, although the voltage applied to the gate electrode 52 after the single electron increases to predetermined voltage, further single electron tunneling is blockaded, resulting in a single electron charging phenomenon. Current flowing between the source and the drain regions is blocked or not blocked by using the phenomenon, thereby implementing the operation of the single electron memory device.

Specifically, the single electron tunneling through the lower layer 46 is stored in the single electron storage medium 48 by applying a voltage Vd to the drain region and applying a voltage Vg to the gate electrode 52, thereby performing a data write operation.

Next, in a case where the MOSFET is maintained in an "on" state by applying a voltage Vd' to the drain region and applying a voltage Vg' to the gate electrode 52, it is considered that data "1" is read when current between the source and drain regions is more than a reference current, and it is considered that data "0" is read when current between the source and drain regions is less than a reference current, thereby performing a data read operation.

When the source and drain regions and the substrate are maintained in a ground state, and an erase voltage (<0) is applied to the gate electrode 52, an electron stored in the single electron storage medium 48 is discharged, thereby performing a data erase operation.

The above description of the operation of the single electron memory device according to Embodiment 1 also applies to the operation of the single electron memory device according the following Embodiments 2 through 4.

### <Embodiment 2>

The single electron memory device according to a second embodiment is a single electron storage means using quantum dots.

In detail, referring to FIG. 4, a gate lamination pattern P1, which is formed on a channel region of a substrate 40, consists of a lower layer 46, an upper layer 54, and a gate electrode 52, which are sequentially formed. A plurality of vertically spaced-apart first and second quantum dots 54a and 54b are included in the upper layer 54. The fist quantum dots 54a are formed on the lower layer 46, and the second quantum dots 54b are formed at a predetermined interval above the first quantum dots 54a and are contact with the bottom suface of the gate electrode 52. The first quantum dots 54a function as the single electron storage medium (48 of FIG. 3) of the first embodiment.

### <Embodiment 3>

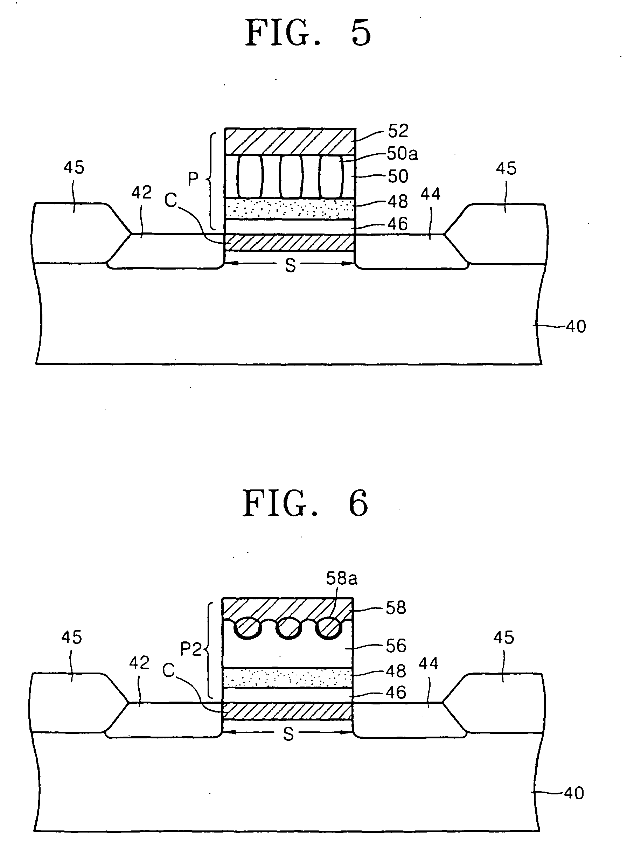

As shown in FIG. 5, the structure of the single electron memory device according to a third embodiment is almost the same as that of the single electron memory device according to the first embodiment. However, quantum dots 50a included between a gate electrode 52 and a single electron storage medium 48 are not only in contact with the bottom surface of the gate electrode 52 but are also in contact with the single electron storage medium 48. In this case, since the gate electrode 52 locally contacts the nano scale single electron storage medium 48, the local charging rate of the single electron storage medium 48 may increase.

### <Embodiment 4>

The single electron memory device according a fourth embodiment includes an upper layer having the same effects as quantum dots, instead of including quantum dots on the bottom surface of the gate electrode in the structure of a gate lamination pattern.

In detail, referring to FIG. 6, a gate lamination pattern P2 consists of a lower layer 46, a single electron storage medium 48, an upper layer 56, and a gate electrode 58, which are sequentially formed. The surface of the upper layer 56 is uneven. As a result, the bottom surface of the gate electrode 58 formed on the upper layer 56 is also uneven. Downward protruding portions 58a of the bottom surface of the gate electrode 58 filling recessed portion in the surface of the upper layer 56 are nearer to the single electron storage medium 48 than other portions, and the single electron storage medium 48 can be locally charged from the protruding portions 58a. As a result, the protruding portions 58a on the bottom surface of the gate electrode 58 are the same as quantum dots contacting the surface when the bottom surface of the gate electrode 58 is a smooth plane.

Next, embodiments of a method for manufacturing a single electron memory device according to the present invention will be described.

### <Embodiment 1>

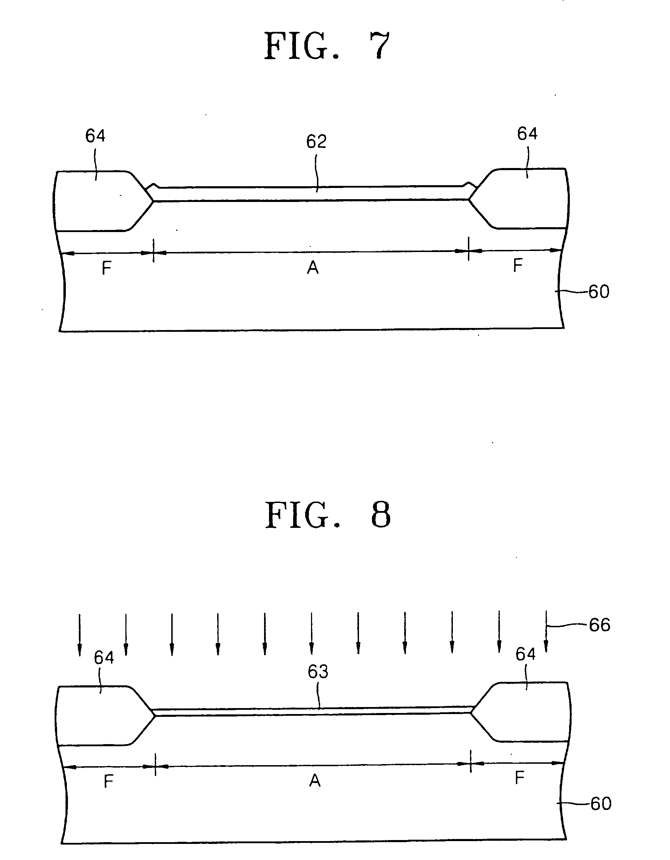

Referring to FIG. 7, an active region A on which a semiconductor device is formed, and a field region F for insulating a semiconductor device are defined on a substrate 60 formed of a P-type or N-type semiconductor. An insulating layer pattern 62 is formed on the substrate 60 to cover the active region A. A field oxide layer 64 is formed on the field region F by using the insulating layer pattern 62 as a mask. The field oxide layer 64 is a LOGOS oxide formed by oxidizing the field region F. Next, the insulating layer pattern 62 is removed.

Referring to FIG. 8, a sacrificial oxide layer 63 is formed on a region from which the insulating layer pattern 62 is removed, and then, conductive impurities 66 for forming a channel region are ion implanted into the entire surface of the sacrificial oxide layer 63. Next, the sacrificial oxide layer 63 is removed.

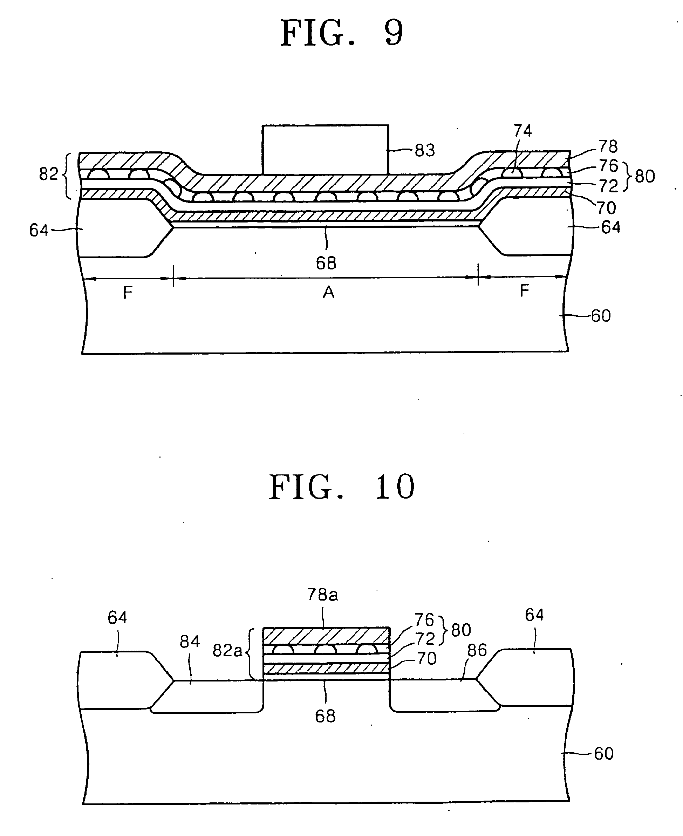

Subsequently, referring to FIG. 9, a gate insulating layer 68 is formed on the active region A. The gate insulating layer 58 is a tunneling layer for single electron tunneling and is used as a lower layer of a gate laminated pattern. As a result, hereinafter, the gate insulating layer 68 is referred to as a lower layer 68. The lower layer 68 is formed of a material selected from the group consisting of silicon oxide (SiO₂), alumina (Al₂O₃), tantalum oxide (TaO₂), and titanium oxide (TiO₂), preferably, silicon oxide (SiO₂). A single electron storage medium 70 and a first upper layer 72 are sequentially formed on the lower layer 68. Preferably, the single electron storage medium 70 is formed of nano scale silicon nitride (Si₃N₄) having a quantized trap site at an interface with the lower layer 68 or in a bulk. However, the single electron storage medium 70 may be formed of a semiconductor material such as silicon (Si), a compound semiconductor material such as silicon germanium (SiGe) or gallium arsenide (GaAs), or a metal, for example, aluminum (Al). Preferably, the first upper layer 72 is formed of the same material as the lower layer 68, which is preferably silicon oxide (SiO₂), but may be formed of a material different from the lower layer 68.

A plurality of quantum dots 74, a second upper layer 76, and a gate electrode layer 78 are sequentially formed on the first upper layer 72. The quantum dots 74 are formed by a selective growth method, or a self-assembled growth method, or a nano-scale lithography method. The second upper layer 76 is preferably formed of the same material as the first upper layer 72. Thus, hereinafter, the first and second upper layers 72 and 76 are referred to as an upper layer 80. The gate electrode layer 78 is formed of a material selected from the group consisting of a doped single semiconductor material such as doped silicon (Si) layer, a compound semiconductor material such as silicon germanium (SiGe) or gallium arsenide (GaAs), and a metal such as aluminum (Al). The doped silicon (Si) layer may be formed of a silicon layer in which conductive impurities are previously doped or a pure silicon layer considering that the impurities are diffused in a next process in which conductive impurities are injected in the entire surface of a substrate.

Meanwhile, in order to apply voltage to the quantum dots 74, the gate electrode layer 78 should be in contact with the quantum dots 74. Thus, in a case where the quantum dots 74 are not exposed on the surface of the second upper layer 76 after the second upper layer 76 is formed, the second upper layer 76 is polished until the quantum dots 74 are exposed to contact the gate electrode layer 78. The polishing is performed by a chemical mechanical polishing (CMP) method, or an etch back method.

In this way, a gate lamination pattern 82 including the lower layer 68, the sinle electron storage medium 70, and the upper layer 80 including the quantum dots 74 is formed on the substrate 60.

Next, a photosensitive layer (not shown) is coated on the gate electrode layer 78, and then, the photosensitive layer is patterned by using a nano-scaled lithography method, for example, a lithography method using an electron beam. In this way, a photosensitive layer pattern 83 for defining a nano scale channel region and a gate is formed on the gate electrode layer 78. Preferably, the photosensitive layer is formed of a resist which appropriate for nano-scale lithography.

The lower layer 68, the single electron storage medium 70, the upper layer 80 including the quantum dots 74, and the gate electrode layer 78 are etched in reverse order by using the photosensitive layer pattern 83 as an etching mask, until the substrate 60 is exposed. Next, the photosensitive layer pattern 83 is removed. In this way, as shown in FIG. 10, a gate lamination pattern 82a consisting of the lower layer 68, the single electron storage medium 70, the upper layer 80 including the quantum dots 74, and a gate electrode 78a, is formed on the channel region of the substrate 60.

Referring to FIG. 10, first and second conductive impurity regions 84 and 86 are formed to a predetermined depth by implanting conductive impurities into the entire surface of the substrate 60 using the gate lamination pattern 82a as an etching mask. P-type conductive impurities are used when the substrate 60 is an N-type substrate, and N-type conductive impurities are used when the substrate 60 is a P-type substrate. The first conductive impurity region 84 is a source region, and the second conductive impurity region 86 is a drain region. In this way, the single electron memory device according to the first embodiment is completed. Next, a process of forming a gate spacer (not shown) at the side of the gate lamination pattern 82a, and a process of implanting conductive impurities into the entire surface of the substrate by using the gate lamination pattern 82a as a mask may be further performed. The conductive impurities are implanted deeper than when conductive impurities are implanted into the first and second conductive impurity regions 84 and 86. In this way, the source and drain regions are formed of an LDD-shape.

### <Embodiment 2>

In a method for manufacturing the single electron memory device according to the second embodiment, the step of forming a single electron storage medium in a gate lamination pattern is different from the first embodiment.

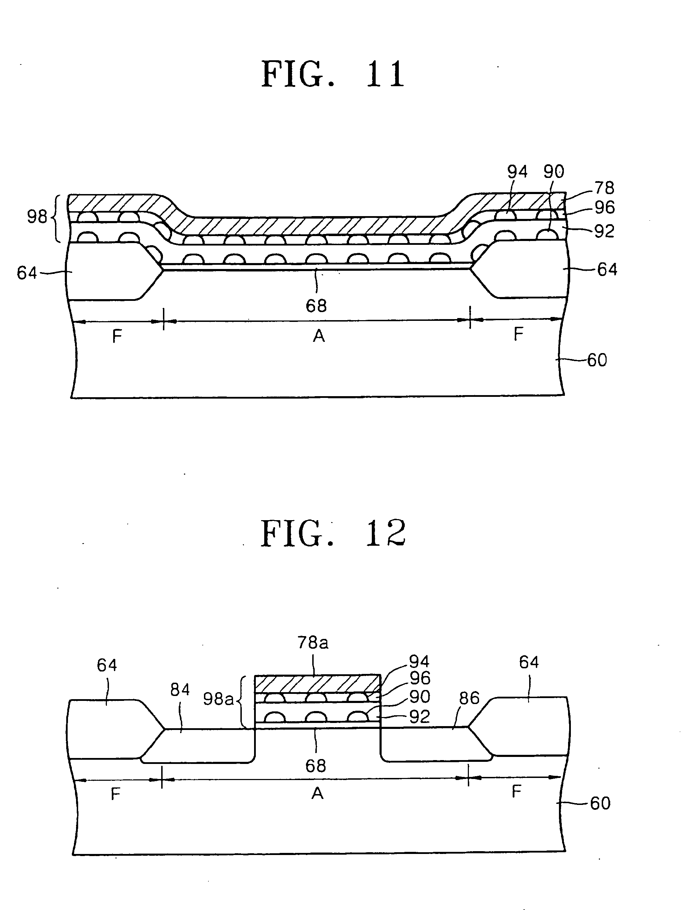

In detail, referring to FIG. 11, the step of forming a lower layer 68 follows the first embodiment. Next, first quantum dots 90 are formed on the lower layer 68. The first quantum dots 90 are used as a single electron storage means for storing a single electron tunneling through the lower layer 68, like in the single electron storage medium 70. The first quantum dots 90 are formed in the same way as the quantum dots 74 are fromed in the first embodiment. An intermediate layer 92 for covering the first quantum dots 90 is formed on the lower layer 68. The intermediate layer 92 is formed of silicon oxide (SiO₂) or may be formed in the same way as the lower layer 68 or the upper layer 80 in the first embodiment. Also, the intermediate layer 92 is preferably formed to a thickness sufficient to cover the first quantum dots 90. Second quantum dots 94 are formed on the intermediate layer 92. The second quantum dots 94 are formed by the same method as used to form the first quantum dots 90.

Preferably, the first and second quantum dots 90 and 94 are formed to a size enabling single electron tunneling at room temperature. For example, in a case where the first and second quantum dots 90 and 94 are formed of silicon (Si), their size is preferably less than 10 nm.

An upper layer 96 for covering the second quantum dots 94 is formed on the intermediate layer 92. The upper layer 96 is formed of the same material as that of the intermediate layer 92. In a case where the second quantum dots 94 are not exposed, the entire surface of the upper layer 96 is polished until the second quantum dots 94 are exposed, as described in the first embodiment.

Subsequently, a gate electrode layer 78 is formed on the upper layer 96. In this way, a gate lamination layer 98 consisting of the lower layer 68, the intermediate layer 92, the upper layer 96 including the second quantum dots 94, and the gate electrode layer 78, is formed on the substrate 60. Next, a step of patterning the gate lamination layer 98 in a nano scale and forming a gate lamination pattern 98a of a nano scale on the substrate 60, as shown in FIG. 12, is performed in the same way as the step of forming the gate lamination pattern 82a in Embodiment 1.

### <Embodiment 3>

In a method for manufacturing the single electron memory device according to the third embodiment, quantum dots 74 are formed in contact with a single electron storage medium 70.

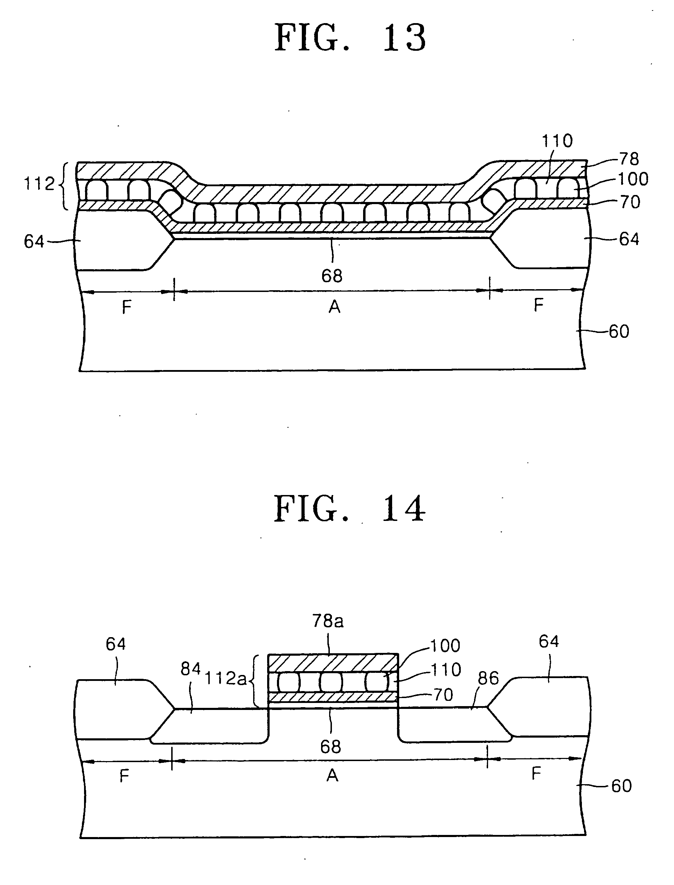

In detail, referring to FIG. 13, the step of forming the single electron storage medium 70 follows the first embodiment. Next, quantum dots 100 are formed on the single electron storage medium 70. The quantum dots 100 are formed like the quantum dots 74 in the first embodiment. Preferably, an upper layer 110 is formed on the single electron storage medium 70 such that the upper portion of the quantum dots 100 are exposed. This result is obtained by controlling conditions of depositing the upper layer 100 on the single electron storage medium 70, or by polishing the entire surface of the upper layer 110 after the upper layer 110 is formed to cover the quantum dots 100. The latter method is more preferable. The polishing is performed by a CMP method, or an etch back method.

Subsequently, a gate electrode layer 78 is formed on the upper layer 110 and the exposed quantum dots 100. In this way, a gate lamination layer 112 is formed on the substrate 60. Next, a step of forming a gate lamination pattern 112a of a nano scale on the substrate 60, as shown in FIG. 14, follows the first embodiment.

### <Embodiment 4>

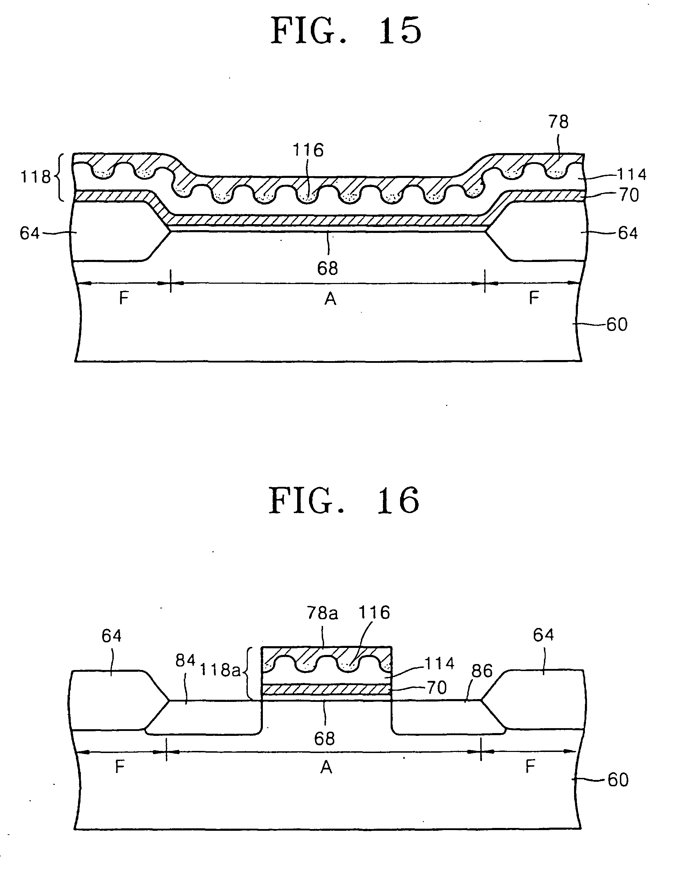

A method for manufacturing the single electron memory device according to the fourth embodiment has the same effects as when the state of the surface of a lower layer contacting the bottom surface of a gate electrode layer is varied and quantum dots are formed, instead of forming the quantum dots contacting the bottom surface of a gate electrode layer between the gate electrode layer and a single electron storage medium. In detail, referring to FIG. 15, the step of forming a single electron storage medium 70 follows the first embodiment. Next, an upper layer 114 is formed on the single electron storage medium 70. At this time, process conditions are controlled to increase the surface roughness of the upper layer 114. As a result, as shown in FIG. 15, the surface of the upper layer 114 is uneven. If a gate electrode layer 78 is formed on the upper layer 114, the gate electrode layer 78 fills an uneven portion of the upper layer 114, and a filled portion 116 in a recessed portion of the upper layer 114 of the gate electrode layer 78 may correspond to the quantum dots having a size appropriate for single electron tunneling at room temperature. In this way, the same effects as those when forming the quantum dots are shown without forming quantum dots.

Next, a gate lamination layer 118 formed on the substrate 60 is patterned, thereby forming a gate lamination pattern 118a of a nano scale on the substrate 60, as shown in FIG. 16. This step follows the first embodiment.

In addition to the first through fourth embodiments of the present invention, there may be combinations thereof or other embodiments.

For example, as a case of combining the second and fourth embodiments, there may be an embodiment of replacing the single electron storage medium 70 of FIG. 7 with the first quantum dots 90 of the second embodiment.

Many details are mentioned in the description, but they should be interpreted as an example of preferred embodiments rather than as defining the scope of the invention. For example, it is obvious to those skilled in the art that the electric resistance of the gate electrode can be reduced more by forming the gate electrode of silicide or polycide, and the single electron storage medium can be formed of a multi-layer. Further, a field oxide layer having another shape (not a LOCOS oxide layer), for example, a trench-type oxide layer, may be formed on a field region of the substrate. Thus, the scope of the invention is defined not by the embodiments but by the appended claims.

As described above, the single electron memory device according to the present invention includes a silicon nitride layer as a nano scale storage medium between quantum dots, which are included on the bottom surface of a gate electrode, and a tunneling layer, which is formed on a nano scale channel region. As a result, the silicon nitride layer can be locally charged even in a nano scale and can retain information longer than a conventional single electron memory device using quantum dots as a data storage electrode. Further, the quantum dots are not included in a lower layer as a tunneling layer, but in an upper layer, thereby keeping the properties of a device intact and allowing the quantum dots to be formed by various methods. Thus, single electron tunneling can be implemented at room temperature, and the properties of a device can be maintained.

## Claims

1. A single electron memory device comprising:
a substrate (40) on which a nano scale channel region is formed between a source and a drain; and
a gate lamination pattern including quantum dots on the channel region; and
wherein the gate lamination pattern comprises:
a lower layer (46) formed on the channel region;
a single electron storage medium (48, 54a) formed on the lower layer, for storing a single electron tunneling through the lower layer;
an upper layer (50, 54, 58) formed on the single electron storage medium; and
a gate electrode (52) formed on the upper layer;
**characterised in that** the upper layer (50, 54, 58) includes quantum dots (50a, 54b, 58a) in contact with the gate electrode.

2. The single electron memory device as claimed in claim 1, wherein the quantum dots (50a, 54b, 58a) are included in the upper layer and are not in contact with the single electron storage medium.

3. The single electron memory device as claimed in claim 1, wherein the quantum dots (50a) are included on the upper layer in a state where is in contact with the single electron storage medium.

4. The single electron memory device as claimed in claim 1, wherein the upper layer is formed of first and second upper layers (56, 58) and the quantum dots (58a) are included in the second upper layer (58).

5. The single electron memory device as claimed in any of claims 1 through 3, wherein the single electron storage medium (48) is formed of a material selected from the group consisting of nano scale silicon nitride (Si₃N₄) having a quantized trap site at an interface with the lower layer or in a bulk, silicon (Si), silicon germanium (SiGe), and gallium arsenide (GaAs).

6. The single electron memory device as claimed in claim 1, wherein the single electron storage medium is quantum dots formed on the lower layer and the upper surface of the upper layer is uneven.

7. A method for manufacturing a single electron memory device including a single electron storage element in a gate lamination pattern formed on a nano scale channel region of a MOSFET, wherein a step of forming the gate lamination pattern comprising the steps of:
(a) sequentially forming a lower layer (68) and a single electron storage medium (70) for storing a single electron tunneling through the lower layer on a substrate;
(b) forming an upper layer (80, 110) on the single electron storage medium;
(c) forming a gate electrode layer (78) on the upper layer; and
(d) patterning the lower layer, the single electron storage medium, the upper layer, and the gate electrode layer, in reverse order;
**characterised in that** the upper layer (50, 54, 58) includes quantum dots (50a, 54b, 58a) in contact with the gate electrode.

8. The method as claimed in claim 7, wherein the step (b) includes the steps of:
forming a first upper layer (72) on the single electron storage medium;
forming the quantum dots (74) on the first upper layer; and
forming a second upper layer (76) to cover the quantum dots on the first upper layer.

9. The method as claimed in claim 7, wherein the step (c) further includes the step of polishing the upper layer until the quantum dots are exposed.

10. The method as claimed in claim 8, wherein the step (c) further includes the step of polishing the second upper layer until the quantum dots are exposed.

11. The method as claimed in claim 7, wherein the step (b) further includes the steps of:
forming the quantum dots (100) on the single electron storage medium (70); and
forming the upper layer (110) to cover the quantum dots on the single electron storage medium.

12. The method as claimed in claim 11, wherein the step (c) further includes the step of polishing the upper layer until the quantum dots are exposed.

13. The method as claimed in any of claims 7, 8 and 11, wherein the single electron storage medium is formed of a material selected from the group consisting of silicon nitride (Si₃N₄), silicon (Si), silicon germanium (SiGe), and gallium arsenide (GaAs).

14. The method as claimed in claim 7, wherein the single electron storage medium is quantum dots and the surface of the upper layer is uneven.

## Patentansprüche

1. Einzelelektronen-Speichergerät, das Folgendes umfasst:
ein Substrat (40), auf dem ein Kanalbereich im Nanomaßstab zwischen einer Source und einem Drain ausgebildet ist; und
eine Gate-Laminierungsstruktur, die Quantenpunkte enthält,
auf dem Kanalbereich; und
wobei die Gate-Laminierungsstruktur Folgendes umfasst:
eine untere Schicht (46), die auf dem Kanalbereich ausgebildet ist;
ein Einzelelektronen-Speichermedium (48, 54a), das auf der unteren Schicht ausgebildet ist, zum Speichern einer Einzelelektronentunnelung durch die untere Schicht;
eine obere Schicht (50, 54, 58), die auf dem Einzelelektronen-Speichermedium ausgebildet ist; und
eine Gate-Elektrode (52), die auf der oberen Schicht ausgebildet ist;
**dadurch gekennzeichnet, dass** die obere Schicht (50, 54, 58) Quantenpunkte (50a, 54b, 58a) in Kontakt mit der Gate-Elektrode enthält.

2. Einzelelektronen-Speichergerät nach Anspruch 1, wobei die Quantenpunkte (50a, 54b, 58a) in der oberen Schicht enthalten sind und nicht in Kontakt mit dem Einzelelektronen-Speichermedium sind.

3. Einzelelektronen-Speichergerät nach Anspruch 1, wobei die Quantenpunkte (50a) auf der oberen Schicht in einem Zustand enthalten sind, in dem Kontakt mit dem Einzelelektronen-Speichermedium besteht.

4. Einzelelektronen-Speichergerät nach Anspruch 1, wobei die obere Schicht aus einer ersten und einer zweiten oberen Schicht (56, 58) ausgebildet ist und die Quantenpunkte (58a) in der zweiten oberen Schicht (58) enthalten sind.

5. Einzelelektronen-Speichergerät nach einem der Ansprüche 1 bis 3, wobei das Einzelelektronen-Speichermedium (48) aus einem Material ausgebildet ist, das aus der Gruppe bestehend aus Siliziumnitrid (Si₃N₄) im Nanomaßstab mit einer quantisierten Haftstelle an einer Grenzfläche mit der unteren Schicht oder in einer Masse, Silizium (Si), Siliziumgermanium (SiGe) und Galliumarsenid (GaAs) ausgewählt ist.

6. Einzelelektronen-Speichergerät nach Anspruch 1, wobei es sich bei dem Einzelelektronen-Speichermedium um Quantenpunkte handelt, die auf der unteren Schicht ausgebildet ist, und die obere Fläche der oberen Schicht uneben ist.

7. Verfahren zur Herstellung eines Einzelelektronen-Speichergeräts, das ein Einzelelektronen-Speicherelement in einer Gate-Laminierungsstruktur enthält, die auf einem Kanalbereich im Nanomaßstab eines MOSFET ausgebildet ist, wobei ein Schritt des Ausbildens der Gate-Laminierungsstruktur die folgenden Schritte umfasst:
(a) sequentielles Ausbilden einer unteren Schicht (68) und eines Einzelelektronen-Speichermediums (70) zum Speichern einer Einzelelektronentunnelung durch die untere Schicht auf einem Substrat;
(b) Ausbilden einer oberen Schicht (80, 110) auf dem Einzelelektronen-Speichermedium;
(c) Ausbilden einer Gate-Elektrodenschicht (78) auf der oberen Schicht und
(d) Strukturieren der unteren Schicht, des Einzelelektronen-Speichermediums, der oberen Schicht und der Gate-Elektrodenschicht in umgekehrter Reihenfolge;
**dadurch gekennzeichnet, dass** die obere Schicht (50, 54, 58) Quantenpunkte (50a, 54b, 58a) in Kontakt mit der Gate-Elektrode enthält.

8. Verfahren nach Anspruch 7, wobei der Schritt (b) die folgenden Schritte umfasst:
Ausbilden einer ersten oberen Schicht (72) auf dem Einzelelektronen-Speichermedium;
Ausbilden der Quantenpunkte (74) auf der ersten oberen Schicht und
Ausbilden einer zweiten oberen Schicht (76), um die Quantenpunkte auf der ersten oberen Schicht abzudecken.

9. Verfahren nach Anspruch 7, wobei der Schritt (c) weiterhin den Schritt des Polierens der oberen Schicht beinhaltet, bis die Quantenpunkte freigelegt sind.

10. Verfahren nach Anspruch 8, wobei der Schritt (c) weiterhin den Schritt des Polierens der zweiten oberen Schicht beinhaltet, bis die Quantenpunkte freigelegt sind.

11. Verfahren nach Anspruch 7, wobei der Schritt (b) weiterhin die folgenden Schritte beinhaltet:
Ausbilden der Quantenpunkte (100) auf dem Einzelelektronen-Speichermedium (70) und
Ausbilden der oberen Schicht (110), um die Quantenpunkte auf dem Einzelelektronen-Speichermedium abzudecken.

12. Verfahren nach Anspruch 11, wobei der Schritt (c) weiterhin den Schritt des Polierens der oberen Schicht beinhaltet, bis die Quantenpunkte freigelegt sind.

13. Verfahren nach einem der Ansprüche 7, 8 und 11, wobei das Einzelelektronen-Speichermedium aus einem Material ausgebildet ist, das aus der Gruppe bestehend aus Siliziumnitrid (Si₃N₄), Silizium (Si), Siliziumgermanium (SiGe) und Galliumarsenid (GaAs) ausgewählt ist.

14. Verfahren nach Anspruch 7, wobei es sich bei dem Einzelelektronen-Speichermedium um Quantenpunkte handelt und die Oberfläche der oberen Schicht uneben ist.

## Revendications

1. Mémoire à électron unique comprenant :
un substrat (40) sur lequel est formée une zone de canal à l'échelle nanométrique entre une source et un drain ; et
un motif de lamination de porte comprenant des points quantiques sur la zone de canal ; et
dans laquelle le motif de lamination de porte comprend :
une couche inférieure (46) formée sur la zone de canal ;
un support de stockage à électron unique (48, 54a) formé sur la couche inférieure, pour stocker un électron unique traversant la couche inférieure ;
une couche supérieure (50, 54, 58) formée sur le support de stockage à électron unique ; et
une gâchette (52) formée sur la couche supérieure ;
**caractérisée en ce que** la couche supérieure (50, 54, 58) comprend des points quantiques (50a, 54b, 58a) en contact avec la gâchette.

2. Mémoire à électron unique selon la revendication 1, dans laquelle les points quantiques (50a, 54b, 58a) sont inclus dans la couche supérieure et ne sont pas en contact avec le support de stockage à électron unique.

3. Mémoire à électron unique selon la revendication 1, dans laquelle les points quantiques (50a) sont inclus sur la couche supérieure dans un état où elle est en contact avec le support de stockage à électron unique.

4. Mémoire à électron unique selon la revendication 1, dans laquelle la couche supérieure est constituée de première et deuxième couches supérieures (56, 58) et les points quantiques (58a) sont inclus dans la deuxième couche supérieure (58).

5. Mémoire à électron unique selon l'une quelconque des revendications 1 à 3, dans laquelle le support de stockage à électron unique (48) est constitué d'un matériau sélectionné dans le groupe comprenant le nitrure de silicium à échelle nanométrique (Si₃N₄) ayant un site piège quantifié à une interface avec la couche inférieure ou dans une masse, le silicium (Si), le silicium-germanium (SiGe), et l'arséniure de gallium (GaAs).

6. Mémoire à électron unique selon la revendication 1, dans laquelle le support de stockage à électron unique est constitué de points quantiques formés sur la couche inférieure et la surface supérieure de la couche supérieure est inégale.

7. Procédé de fabrication d'une mémoire à électron unique comprenant un élément de stockage à électron unique dans un motif de lamination de porte formé sur une zone canal à échelle nanométrique d'un transistor MOSFET, dans lequel une étape de formation du motif de lamination de porte comprend les étapes consistant à :
(a) former séquentiellement une couche inférieure (68) et un support de stockage à électron unique (70) pour stocker un électron unique traversant la couche inférieure sur un substrat ;
(b) former une couche supérieure (80, 110) sur le support de stockage à électron unique ;
(c) former une couche gâchette (78) sur la couche supérieure ; et
(d) former un motif sur la couche inférieure, le support de stockage à électron unique, la couche supérieure, et la couche gâchette, dans l'ordre inverse ;
**caractérisé en ce que** la couche supérieure (50, 54, 58) comprend des points quantiques (50a, 54b, 58a) en contact avec la gâchette.

8. Procédé selon la revendication 7, dans lequel l'étape (b) comprend les étapes consistant à :
former une première couche supérieure (72) sur le support de stockage à électron unique ;
former les points quantiques (74) sur la première couche supérieure ; et
former une deuxième couche supérieure (76) pour couvrir les points quantiques sur la première couche supérieure.

9. Procédé selon la revendication 7, dans lequel l'étape (c) comprend en outre l'étape consistant à polir la couche supérieure jusqu'à ce que les points quantiques soient exposés.

10. Procédé selon la revendication 8, dans lequel l'étape (c) comprend en outre l'étape consistant à polir la deuxième couche supérieure jusqu'à ce que les points quantiques soient exposés.

11. Procédé selon la revendication 7, dans lequel l'étape (b) comprend en outre les étapes consistant à :
former les points quantiques (100) sur le support de stockage à électron unique (70) ; et
former la couche supérieure (110) pour couvrir les points quantiques sur le support de stockage à électron unique.

12. Procédé selon la revendication 11, dans lequel l'étape (c) comprend en outre l'étape consistant à polir la couche supérieure jusqu'à ce que les points quantiques soient exposés.

13. Procédé selon l'une quelconque des revendications 7, 8 et 11, dans lequel le support de stockage à électron unique est constitué d'un matériau sélectionné dans le groupe comprenant le nitrure de silicium (Si₃N₄), le silicium (Si), le silicium-germanium (SiGe) et l'arséniure de gallium (GaAs).

14. Procédé selon la revendication 7, dans lequel le support de stockage à électron unique est constitué de points quantiques et la surface de la couche supérieure est inégale.
